Europäisches Patentamt

European Patent Office

Office européen des brevets

(11) Veröffentlichungsnummer: **0 379 739**
**A2**

(12) **EUROPÄISCHE PATENTANMELDUNG**

(21) Anmeldenummer: **89124159.8**

(51) Int. Cl.⁵: **H01J 37/30, H01J 37/315**

(22) Anmeldetag: **29.12.89**

(30) Priorität: **26.01.89 DE 3902274**

(43) Veröffentlichungstag der Anmeldung:
**01.08.90 Patentblatt 90/31**

(84) Benannte Vertragsstaaten:
**CH DE FR GB LI**

(71) Anmelder: **LEYBOLD AKTIENGESELLSCHAFT**
**Wilhelm-Rohn-Strasse 25**
**D-6450 Hanau am Main 1(DE)**

(72) Erfinder: **Benes, Ewald, Dr. Dipl.-Ing.**
**Klosterstrasse 23**
**A-2362 Biedermannsdorf(AT)**
Erfinder: **Gröschl, Martin, Dipl.-Ing.**
**Heinestrasse 22/24**
**A-1020 Wien(AT)**
Erfinder: **Schmid, Michael, Dipl.-Ing.**
**Neustiftgasse 57-59/2/66**
**A-1070 Wien(AT)**
Erfinder: **Siegmund, Hans-Joachim**
**Fasanenweg 7**
**D-6113 Babenhausen(DE)**
Erfinder: **Thomas, Friedrich-Werner, Dr.Ing.**
**Schwarzwaldweg 2**
**D-6460 Gelnhausen 2(DE)**
Erfinder: **Thorn, Gernot, Dipl.-Ing.**
**Posener Strasse 8**
**D-6450 Hanau(DE)**

(74) Vertreter: **Schickedanz, Willi, Dipl.-Ing.**
**Langener Strasse 68**
**D-6050 Offenbach/Main(DE)**

(54) **Einrichtung zum Erkennen der Auftreffstelle eines Ladungsträgerstrahls auf einem Target.**

(57) Die Erfindung betrifft eine Einrichtung zum Erkennen der Auftreffstelle (29, 37) eines Ladungsträgerstrahls auf einem Target. Diese Einrichtung weist zwei positionsempfindliche Detektoren (22, 23) oberhalb des Targets auf, die einen vorgegebenen Abstand voneinander und von dem Target haben und auf denen über Abbildungssysteme (24, 25) die Auftreffstelle (29, 37) des Ladungsträgerstrahls mittels Röntgenstrahlen abgebildet wird. Die Ausgangssignale dieser Detektoren (22, 23) werden auf eine besondere Auswerte-Einrichtung gegeben, welche alle drei Raum-Koordinaten der Auftreffstelle (29, 37) des Ladungsträgerstrahls ermittelt.

FIG. 2

# EINRICHTUNG ZUM ERKENNEN DER AUFTREFFSTELLE EINES LADUNGSTRÄGERSTRAHLS AUF EINEM TARGET

Die Erfindung betrifft eine Einrichtung zum Erkennen der Auftreffstelle eine Ladungsträgerstrahls nach dem Oberbegriff des Patentanspruchs 1.

Einrichtungen dieser Art werden insbesondere bei Elektronenstrahl-Verdampferquellen, -Schmelzanlagen und -Schweißkanonen verwendet. Bei allen diesen Anlagen ist es wichtig, den Elektronenstrahl exakt zu führen. So wird zum Beispiel bei den Elektronenstrahl-Verdampferquellen der Elektronenstrahl derart über die Oberfläche des zu verdampfenden Materials bewegt, daß auf einer bestimmten Fläche eine möglichst gleichmäßige Oberflächentemperatur und damit eine über diese Fläche konstante Abdampfrate erzielt wird. Um eine exakte Führung des Elektronenstrahls, der über elektrische und/oder magnetische Felder abgelenkt werden kann, zu ermöglichen, ist es erforderlich, zunächst die Ist-Position genau zu kennen.

Für die Ermittlung der Ist-Position werden verschiedene Eigenschaften ausgenutzt, welche die Auftreffstelle des Elektronenstrahls auf ein Material hat. Eine dieser Eigenschaften besteht darin, daß das Targetmaterial an der Auftreffstelle schmilzt, während es an anderen Stellen noch fest bleibt. Eine andere Eigenschaft ist die erhöhte Aussendung von UV-Licht an der Auftreffstelle und wieder eine andere die Aussendung von Röntgenstrahlen, die beim Abbremsen von elektrisch geladenen Teilchen entstehen.

Für die Überwachung des Strahlauftreffbereichs in Korpuskularstrahl-Bearbeitungsgeräten ist bereits eine Vorrichtung bekannt, die einen Kontroll-Strahlengang für ein Bündel der von dem Strahlauftreffbereich ausgehenden Teilchen- und/oder Röntgenstrahlen besitzt, wobei der Kontrollstrahlengang ein Abbildungssystem zur Abbildung des Strahlauftreffbereichs sowie einen im Bildbereich des Abbildungssystems angeordneten Strahlungsempfänger aufweist (DE-AS 12 99 498). Mit dieser bekannten Vorrichtung ist es indessen nicht möglich, eine präzise Koordinatenangabe der Auftreffstelle des Elektronenstrahls auf einem Target zu erhalten, weil die wirksame Fläche des Strahlungsemofängers kleiner ist als die Fläche des bei optimaler Fokussierung des bearbeitenden Korpuskularstrahls vom Abbildungssystem erzeugten Bildes des Strahlauftreffbereichs, d. h. der gesamte Strahlungsempfänger wird von dem abgebildeten Strahlauftreffbereich überdeckt.

Eine Einrichtung zum Erkennen der Auftreffstelle eines Ladungsträgerstrahls auf einem Target, bei welcher der von einem Abbildungssystem auf einen Sensor abgebildete Auftreffbereich des Elektronenstrahls kleiner ist als der Sensor, ist ebenfalls bekannt (EP-0 184 680 Al). Hierbei ist ein Abbildungssystem vorgesehen, das alle Positionen, welche die Auftreffstelle einnehmen kann, erfaßt und auf die Sensorfläche eines positionsempfindlichen Detektors abbildet. Nachteilig ist bei dieser bekannten Einrichtung, daß das Positions-Istsignal durch eventuell auftretende Niveauänderungen des Schmelguts verfälscht wird, d. h. die ermittelten x,y-Koordinaten der Auftreffstelle werden durch Verändern der z-Koordinate beeinflußt. In großen Aufdampfanlagen, welche das bevorzugte Einsatzgebiet dieses bekannten Positionsgebers darstellen, ist der kürzeste Abstand des Detektors und der Blende von der Targetoberfläche im allgemeinen groß in Relation zur maximalen Höhenänderung der Schmelzgutoberfläche, so daß die durch diese Höhenänderung hervorgerufene Abweichung der angezeigten von den tatsächlichen x,y-Koordinaten vernachlässigbar klein ist.

In kleineren Aufdampfanlagen werden im allgemeinen Elektronenstrahlen niedrigerer Leistung verwendet. Daraus resultiert eine wesentlich geringere Intensität der Röntgenstrahlung, welche für die Positionsdetektion ausgenützt werden kann. In derartigen Anlagen müssen die Positionsdetektoren daher in wesentlich geringerem Abstand zur Targetoberfläche angeordnet werden. Oft ist auch aus konstruktiven Gründen gar nichts anderes möglich, als den Abstand zwischen Targetoberfläche und Positionsdetektor klein zu halten. Damit bewirkt aber aufgrund des anderen Abbildungsmaßstabes eine Veränderung der z-Koordinate des Strahlauftreffpunkts - auch bei gleichbleibenden x,y-Koordinaten - eine Verschiebung des Bildpunktes auf der Detektorfläche, die nicht mehr vernachlässigbar ist. Der Positionsdetektor gemäß EP-0 184 680 Al ist daher für Kleinanlagen, bei denen das Schmelzbad-Niveau variabel ist, weniger geeignet.

Niveauänderungen als solche könnten mit Hilfe von Entfernungsmeßeinrichtungen erfaßt werden, wie sie beispielsweise in modernen Autofocus-Kameras verwendet werden. Derartige Entfernungsmeßeinrichtungen ermöglichen jedoch keine Erfassung der x- und y-Koordinaten.

Der Erfindung liegt deshalb die Aufgabe zugrunde, ein Positions-Istsignal des Auffreffpunkts eines Elektronenstrahls auf einem Target zu erhalten, das vom Schmelzgutniveau unabhängig ist.

Diese Aufgabe wird gemäß den Merkmalen des Patentanspruchs 1 gelöst.

Der mit der Erfindung erzielte Vorteil besteht insbesondere darin, daß die exakte Position der Auftreffstelle eines Elektronenstrahls auf der Oberfläche eines Targets auch dann ermittelt werden kann, wenn sich das Niveau des Schmelzguts verändert, was bei allen Verdampferanlagen von Bedeutung ist, bei denen kein kontinuierlicher Materialnachschub während des Verdampfungsvorgangs erfolgt. Darüberhinaus kann zugleich mit der Auftreffposition des Elektronenstrahls auf der Targetoberfläche auch der Füllstand des Schmelztiegels überwacht und somit ein Einbrennen des Elektronenstrahls in dun Boden des Tiegels verhindert werden. Weiterhin ist mit der Erfindung die Bestimmung aller drei Raumkoordinaten der Auftreffstelle des Elektronenstrahls in verschiedenen Koordinatensystemen (z. B. kartesische Koordinaten, Polarkoordinaten, Kugelkoordinaten) möglich. Unter der Auftreffstelle des Ladungsträgerstrahls wird der Ort des Schwerpunkts der Leistungsdichte-Verteilung der auf die Targetoberfläche treffenden Ladungsträger verstanden.

Mit der Erfindung ist es auch möglich, die Koordinaten der Auftreffstelle - also einschließlich der z-Koordinate - auch dann exakt zu ermitteln, wenn die Detektoren nahe an der Targetoberfläche angeordnet sind. Eine Veränderung irgendeiner Koordinate der Auftreffstelle hat keinen Einfluß mehr auf die jeweils anderen, d. h. nicht korrelierten, ermittelten Koordinaten. Bei einer Reihe von Anwendungsfällen ist es nicht erforderlich, die exakte Ermittlung der Strahlposition an allen Punkten der Targetoberfläche zu ermitteln, sondern es wird lediglich die Festhaltung des Auftreffbereichs in der Mitte der Targetoberfläche gewünscht. Für diese Fälle kann in vorteilhafter Weise eine vereinfachte Version der Erfindung in Form eines Mittenpositionsgebers zur Anwendung gelangen. Im Gegensatz zu bekannten Positionsgebern ermöglicht auch diese vereinfachte Version die exakte Bestimmung - wenngleich nur einer einzigen - ausgezeichneten Position, z. B. der Mittenposition, auch dann noch, wenn sich das Schmelzgutniveau und damit die z-Koordinate des Auftreffpunkts verändert.

Ein Ausführungsbeispiel der Erfindung ist in der Zeichnung dargestellt und wird im folgenden näher beschrieben. Es zeigen:

Fig. 1a einen Tiegel und eine Elektronenstrahlkanone, wobei das Schmelzgut im Tiegel einen hohen Pegel hat;

Fig. 1b dieselbe Anordnung wie in Fig. 1a, jedoch mit niedrigem Schmelzgutpegel;

Fig. 2 das Prinzip einer erfindungsgemäßen Anordnung zur Bestimmung der drei Ortskoordinaten x, y und z des Auftreffpunkts eines Ladungsträgerstrahls auf einem Target;

Fig. 3 eine Auswerteschaltung für einen erfindungsgemäßen Positionsdetektor;

Fig. 4 eine Anordnung mit einem erfindungsgemäßen Elektronenstrahl-Mittenpositionsdetektor für Kleinanlagen;

Fig. 5 einen geschnitten dargestellten Mittenpositionsdetektor;

Fig. 6 eine Auswerteschaltung für einen erfindungsgemäßen Mittenpositionsdetektor.

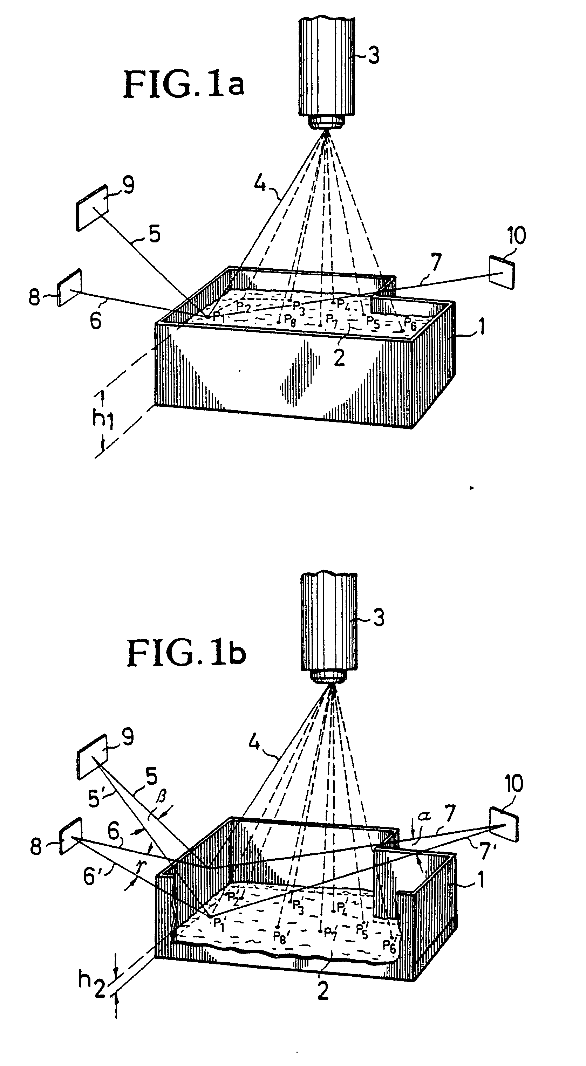

In der Fig. 1a ist ein Tiegel 1 mit Schmelzgut 2 dargestellt, über dem sich eine Elektronenstrahlkanone 3 befindet. Diese Elektronenstrahlkanone 3 sendet einen Elektronenstrahl 4 auf die Oberfläche des Schmelzguts 2, wodurch im Punkt $P_1$ Röntgenstrahlen 5, 6, 7 entstehen, die von Sensoren 8, 9, 10 erfaßt werden. Durch nicht dargestellte Ablenkeinrichtungen kann der Elektronenstrahl 4 in verschiedene Richtungen abgelenkt werden, so daß er beispielsweise in den Punkten $P_2$ bis $P_8$ auf die Oberfläche des Schmelzguts auftrifft. Die Röntgenstrahlen werden dann entsprechend von diesen Punkten $P_2$ bis $P_8$ emittiert. Die Höhe des Schmelzguts 2, bezogen auf die Bodenfläche des Tiegels 1, ist in der Fig. 1a mit $h_1$ bezeichnet. Mit der in der EP-0 184 680 beschriebenen Einrichtung, welche als Sensoren 8, 9, 10 z. B. Lateraldioden vorsieht, können die jeweiligen Positionen $P_1$ bis $P_8$ exakt nach x- und y-Koordinaten angegeben werden, und zwar unabhängig von der jeweiligen Intensität des Elektronenstrahls 4. Verändert sich jedoch der Pegel, indem er beispielsweise - wie in der Fig. 1b gezeigt - auf die Höhe $h_2$ absinkt, so befinden sich die Auftreffpunkte $P_1 \ldots P_8$ nun an anderen x-/y-Koordinaten. Der Elektronenstrahl 4, der in Fig. 1a im Punkt $P_1$ auf die Oberfläche des Schmelzguts traf , trifft bei abgesunkener Oberfläche in Fig. 1b nun überhaupt nicht mehr auf das Schmelzgut 2. Der Auftreffpunkt $P_1'$ , der bezüglich seiner Oberflächen-x-/y-Koordinaten dem Auftreffpunkt $P_1$ entspricht, sendet jetzt Röntgenstrahlen $5'$, $6'$, $7'$ in Richtungen aus, die zu den früheren Richtungen und bezogen auf die Sensoren 8, 9, 10 einen Winkel $\alpha$, $\beta$, $\gamma$ bilden. Mit der in den Fig. 1a und 1b dargestellten Anordnung und einer elektrischen Auswerteschaltung für positionsempfindliche Strahlungsdetektoren, wie sie beispielsweise in EP-0 184 680 beschrieben ist, lassen sich daher die x- und y-Koordinaten des Auftreffpunkts eines Ladungsträgerstrahls auf einem Target nur dann exakt bestimmen, wenn der Abstand der Sensoren von der Oberfläche des Schmelzgutes konstant bleibt. Will man den Einfluß einer Niveauänderung des Schmelzgutes auf die x-y-Koordinaten bei der Anordnung gemäß EP-0 184 680 vermeiden, so müßte man die Sensoren entsprechend der Niveauänderung des Schmelzgutes mitbewegen. Dies würde jedoch neben dem zusätzlichen Aufwand für die Bewegung der Sensoren vor allem die von den x- und y-Koordinaten unabhängige Bestimmung der z-Koordinate des Auftreffpunkts des Ladungsträgerstrahls erfordern. Diese unabhängige Bestimmung der z-Koordinate ist mit der beschriebenen Anordnung aber nicht möglich, da jeder beliebig über dem Target angeordnete positionsempfindliche Detektor Signale liefert, die von wenigstens zwei Koordinaten des Auftreffpunkts des Ladungsträgerstrahls abhängen.

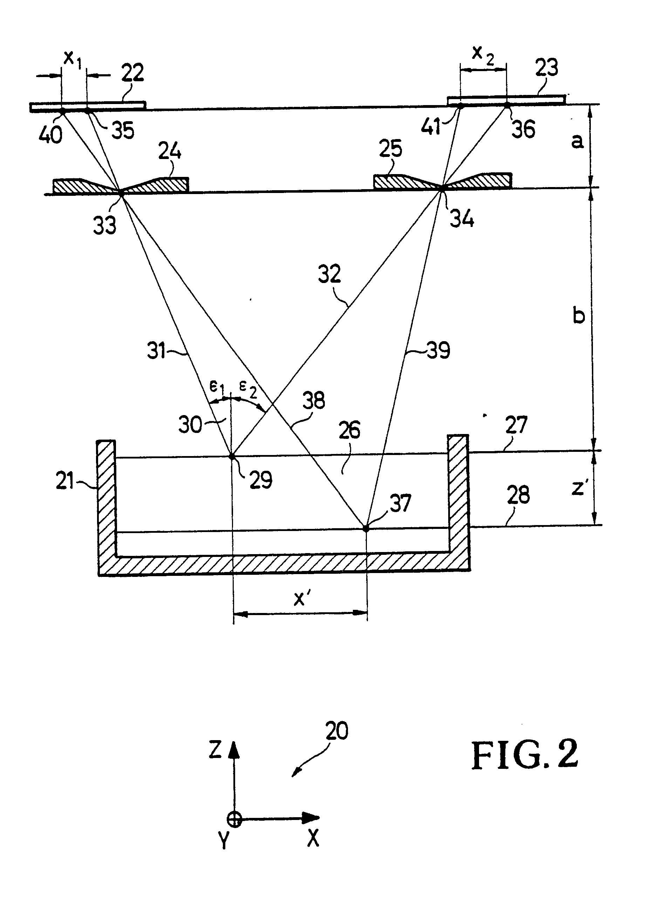

In der Fig. 2 ist das Prinzip der erfindungsgemäßen Einrichtung für die Bestimmung der Ortskoordinaten des Auftreffpunkts eines Ladungsträgerstrahls auf einem Target dargestellt. Die Darstellung erfolgt hierbei mit Hilfe kartesischer Koordinaten gemäß der x,y,z-Zuordnung 20. Die x- und z-Achsen liegen hierbei in der Zeichenebene, während die y-Achse aus der Zeichenebene herausragt. Mit 21 ist ein Tiegel bezeichnet, der im Querschnitt dargestellt ist. Oberhalb des Tiegels 21 befinden sich zwei positionsempfindliche Sensoren 22, 23 sowie zwei Lochblenden 24, 25. Die Lochblenden 24, 25 sind hierbei zwischen dem Tiegel 21 und den Sensoren 22, 23 angeordnet. Die strahlungsempfindlichen Oberflächen der Sensoren 22, 23, die auf ein Target 26 gerichtet sind, liegen parallel zur X-, Y-Ebene. Die Sensoren 22, 23 weisen Positionsempfindlichkeiten entlang den Achsen X und Y auf. Eine Gerade 27 bezeichnet die Schnittlinie der Oberfläche des Targets 26, bei dem es sich z. B. um Schmelzgut handelt, zu einem bestimmten Zeitpunkt $t_1$ mit der X-Z-Ebene.

Eine andere Gerade 28 bezeichnet die Schnittlinie der Oberfläche des Targets 26 zur X-Z-Ebene zu einem anderen Zeitpunkt $t_2$. Mit 29 ist ein beliebig gewählter fester Bezugspunkt auf der Targetoberfläche 27 zum Zeitpunkt $t_1$ bezeichnet. Von diesem Bezugspunkt 29 verlaufen unter den Winkeln $\epsilon_1$ bzw. $\epsilon_2$ zu einer gedachten Flächennormalen 30 zwei Geraden 31, 32 durch Öffnungen 33, 34 der Blenden 24, 25. Diese Geraden 31, 32 treffen in den Punkten 35, 36 auf die röntgenstrahlenempfindlichen Flächen der Sensoren 22, 23. Mit 37 ist der Auftreffort eines nicht dargestellten Ladungsträgerstrahls auf dem Target 26 zum Zeitpunkt $t_2$ bezeichnet. Von diesem Punkt 37, der die Koordinaten $x'$ und $z'$ relativ zum Punkt 29 aufweist, gehen zwei Geraden 38, 39 aus, die den Verlauf der entstehenden Röntgenstrahlen angeben und in den Punkten 40, 41 auf die Sensoren 22, 23 treffen. Der in Richtung der Z-Achse gemessene Abstand der Blendenöffnungen 33, 34 zu den Sensoren ist mit a, jener von den Blendenöffnungen 33, 34 zur Schmelzgutoberfläche 27 zum Zeitpunkt $t_1$ ist mit b bezeichnet.

Verschiebt sich nun der Auftreffort des Ladungsträgerstrahls auf dem Schmelzgut vom Punkt 29 zum Punkt 37, so registriert der Sensor 22 auf seiner Oberfläche eine Verschiebung der Röntgenstrahlen entlang der X-Achse um die Strecke $x_1$, während der Sensor 23 eine Verschiebung um die Strecke $x_2$ feststellt. Aus geometrischen Überlegungen folgt mit Hilfe des Strahlensatzes die Beziehung

$$\frac{x_1}{x' - z'\tan\epsilon_1} = \frac{a}{b + z'} \qquad (I)$$

bzw.

$$x_1 = \frac{a}{b + z'}(x' - z'\tan\epsilon_1) \qquad (II)$$

Analog gilt im Hinblick auf die Strecke $x_2$ die Gleichung

$$\frac{x_2}{x' + z'\tan\epsilon_2} = \frac{a}{b + z'} \qquad (III)$$

bzw.

$$x_2 = \frac{a}{b + z'}(x' + z'\tan\epsilon_2) \qquad (IV)$$

Durch Subtraktion der Gleichung (II) von der Gleichung (IV) erhält man

$$x_2 - x_1 = \frac{az'}{b + z'}(\tan\epsilon_1 + \tan\epsilon_2) \qquad (V)$$

und daraus durch Umformung

$$z' = b \frac{(x_2 - x_1)}{k_1 a - (x_2 - x_1)} \qquad \text{(VI)}$$

mit $k_1 = \tan_{\epsilon_1} + \tan_{\epsilon_2} = \text{const.}$

Durch die Addition der Gleichungen (II) und (IV) ergibt sich

$$x_2 + x_1 = \frac{a}{b + z'} \left[ 2x' + z'(\tan\varepsilon_2 - \tan\varepsilon_1) \right] \quad \text{(VII)}$$

Wählt man den Bezugspunkt 29 derart, daß $\epsilon_1 = \epsilon_2$, so folgt aus Gleichung (VII)

$$x_2 + x_1 = \frac{2ax'}{b + z'} \qquad \text{(VIII)}$$

Durch Umformung von Gleichung (VIII) erhält man

$x' = \frac{b}{2a}(x_2 + x_1) + \frac{1}{2a}(x_2 + x_1)z'$    (IX)

bei $\epsilon_1 = \epsilon_2$.

In Analogie zur Gleichung (IX) erhält man für die y-Koordinate

$y' = \frac{b}{2a}(y_2 + y_1) + \frac{1}{2a}(y_1 + y_1)z'$    (X)

für $\delta_1 = \delta_2$,

wenn mit $y'$ die y-Koordinate des Punktes 37 relativ zum Punkt 29, mit $y_1$ und $y_2$ die y-Koordinaten der Punkte 40 bzw. 41 relativ zu den Punkten 35 bzw. 36 und mit $\delta_1$ und $\delta_2$ die zu den Winkeln $\epsilon_1$ bzw. $\epsilon_2$ entsprechenden Winkel in der yz-Ebene bezeichnet werden.

Aus den positionsproportionalen Signalen der Sensoren 22 und 23 läßt sich demnach mit der Gleichung (VI) die z-Koordinate des Auftreffpunkts des Ladungsträgerstrahls auf dem Target ermitteln, und bei Kenntnis dieser z-Koordinate können aus den Gleichungen (IX) und (X) die x- und y-Koordinaten bestimmt werden. Die erforderlichen Berechnungen können beispielsweise mit Hilfe eines Mikrocomputers durchgeführt werden.

In vielen Fällen ist der Abstand (a + b) der Detektoren 22, 23 von der Oberfläche 27 des Targets wesentlich größer als die maximale Niveauverschiebung $z'_{max}$ des Schmelzguts. Die Gleichungen (II) und (IV) können dann wie folgt geschrieben werden

$x_1 = \frac{a}{b}(x' - z'\tan\varepsilon_1)$ für $b \gg z'$    (XI)

$x_2 = \frac{a}{b}(x' + z'\tan\varepsilon_2)$ für $b \gg z'$    (XII)

Durch Subtraktion der Gleichung (XI) von der Gleichung (XII) folgt nunmehr:

$$z' = k_2(x_2 - x_1) \text{ mit } k_2 = \frac{b}{a(\tan\varepsilon_1 + \tan\varepsilon_2)} = \text{const.} \qquad \text{(XIII)}$$

Durch Addition der Gleichungen (XI) und (XII) ergibt sich

$x' = \frac{b}{2a}(x_1 + x_2)$ für $\epsilon_1 = \epsilon_2$    (XIV)

Analog ergibt sich wiederum für die y-Koordinate

$y = \frac{b}{2a}(y_1 + y_2)$ für $\delta_1 = \delta_2$    (XV)

Mit Hilfe der Gleichungen (XIII) bis (XV) lassen sich die Koordinaten des Auftreffpunkts eines Ladungsträgerstrahls auf einem Target aus den Signalen der positionsempfindlichen Sensoren 22, 23 in erster Näherung auf einfache Weise, z. B. mit Hilfe einer Analogschaltung, bestimmen.

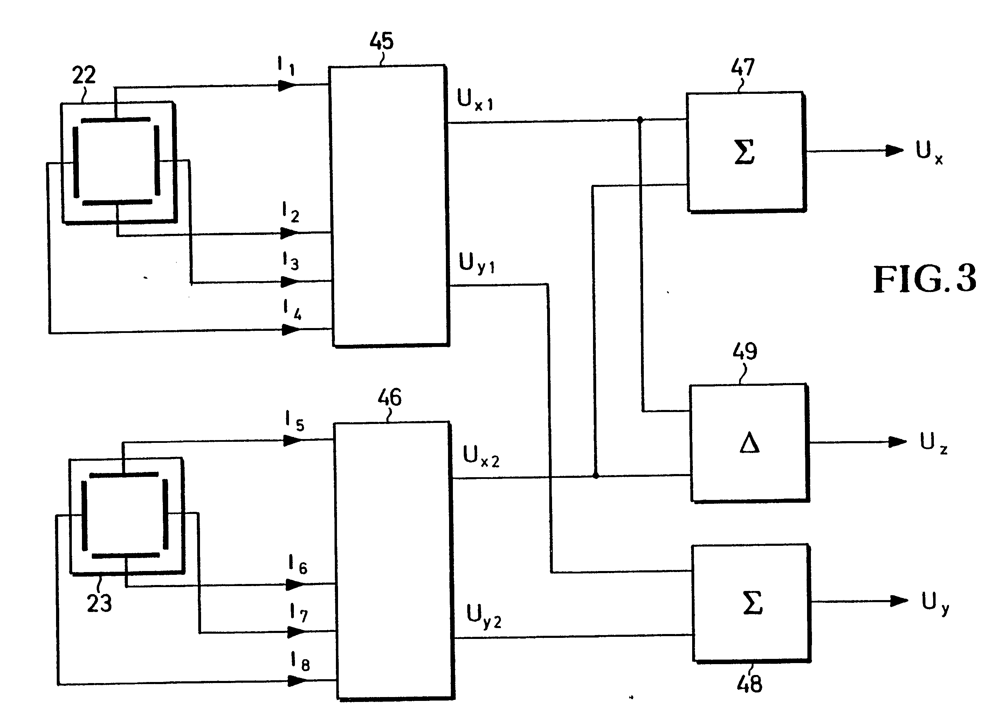

Ein Ausführungsbeispiel einer Auswerteschaltung für einen erfindungsgemäßen Positionsdetektor ist in der Fig. 3 gezeigt und wird im folgenden näher beschrieben.

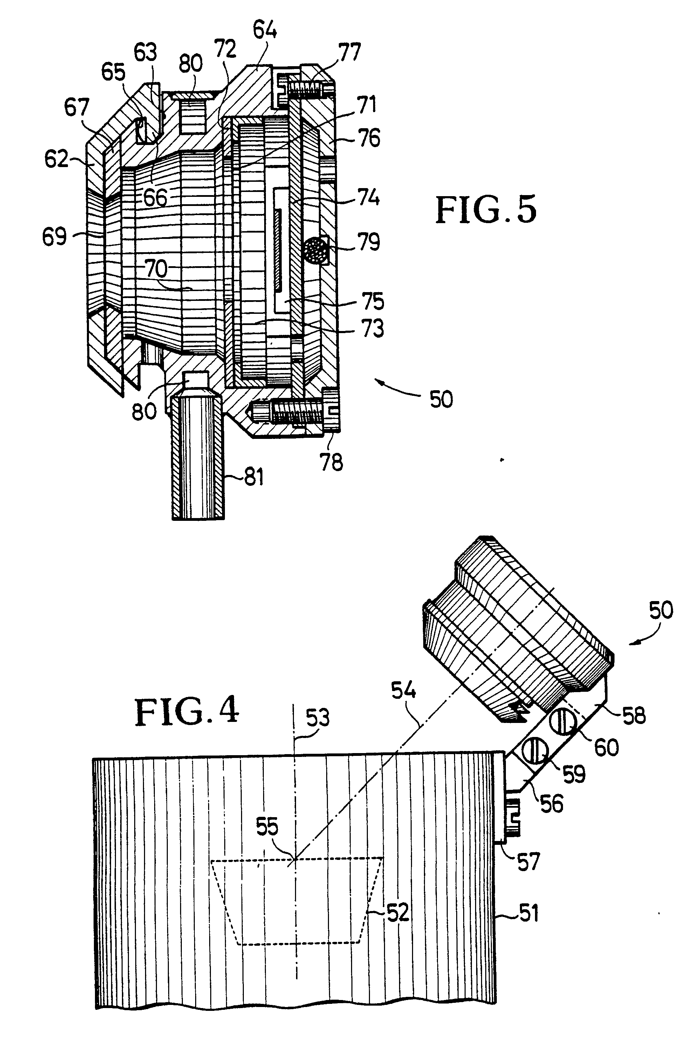

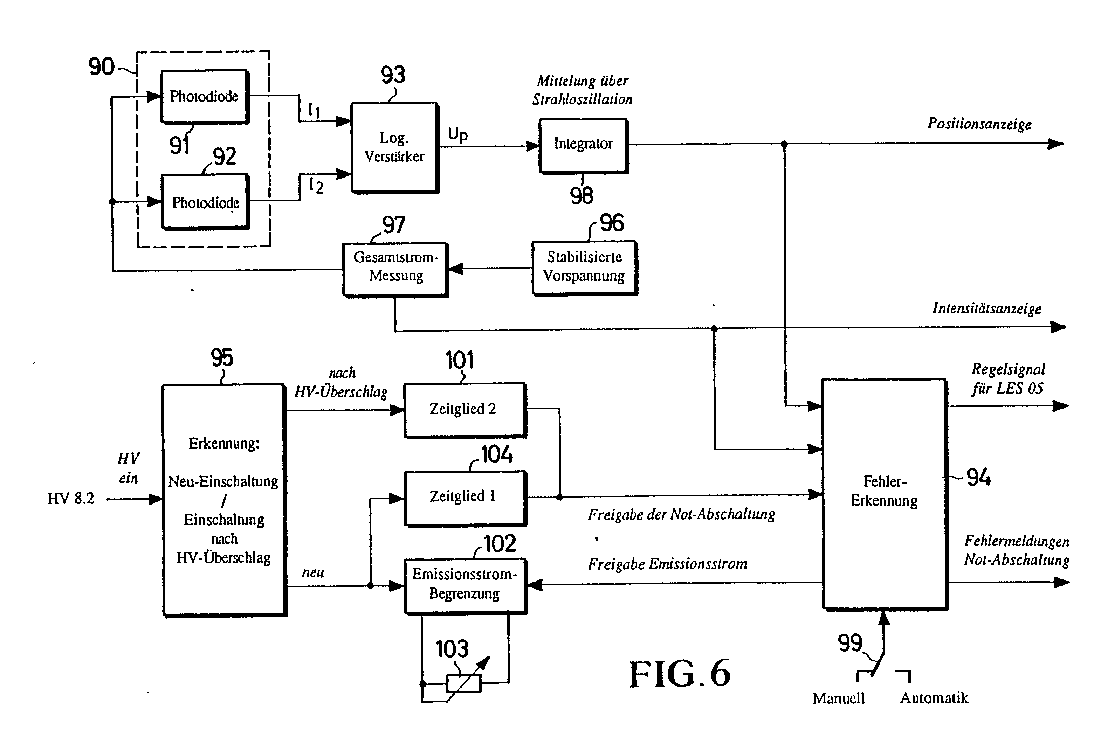

Die von den bidirektional positionsempfindlichen Photosensoren 22 und 23 erzeugten positions- und intensitätsabhängigen Ströme $I_1$ bis $I_8$ werden zunächst in Auswerteschaltungen 45 bzw. 46 in von der Strahlungsintensität unabhängige positionsproportionale elektrische Spannungen $U_{x1}$, $U_{y1}$ bzw. $U_{x2}$, $U_{y2}$ umgewandelt. Dabei ist $U_{x1}$ proportional zur Auslenkung der auf den Sensor 22 treffenden Strahlung in Richtung der X-Achse, $U_{y1}$ ist proportional zur Auslenkung der Strahlung auf dem Sensor 22 in Richtung der Y-Achse. Analoges gilt für die Spannungen $U_{x2}$ und $U_{y2}$ in bezug auf den Sensor 23. Eine Auswerteschaltung 45, 46, wie sie hier zur Anwendung kommen kann, ist beispielsweise in den Fig. 5 und 6 der EP-0 184 680 dargestellt. Dort wird die Differenz jeweils zweier Sensorströme durch deren Summe dividiert. Gemäß der vorliegenden Erfindung werden aus den positionsproportionalen Spannungen $U_{x1}$, $U_{y1}$, $U_{x2}$, $U_{y2}$ über elektronische Additionsschaltungen 47, 48 bzw. eine Subtraktionsschaltung 49 Spannungen $U_x$, $U_y$, $U_z$ gewonnen, welche jeweils ausschließlich von den Koordinaten x bzw. y bzw. z des Auftreffpunkts des Ladungsträgerstrahls auf dem Target abhängen. Die Verknüpfung erfolgt dabei gemäß den Gleichungen (XIII) bis (XV). Es gilt:

$$U_x\alpha\ (U_{x1} + U_{x2}) \qquad (XVI)$$
$$U_y\alpha\ (U_{y1} + U_{y2}) \qquad (XVII)$$
$$U_z\alpha\ (U_{x1} - U_{x2}) \qquad (XVIII)$$

Die so erzeugten positionsproportionalen Spannungen $U_x$ und $U_y$ können als Regelgröße für die Regelung der Auftreffposition eines Elektronenstrahls auf einem Target in Elektronenstrahl-Verdampferanlagen herangezogen werden, wobei die Istposition des Strahls auch dann richtig erfaßt wird, wenn sich das Niveau des Schmelzguts verschiebt. Die Spannung $U_z$ kann zur Überwachung der Höhe des Schmelzguts verwendet werden und insbesondere als Kriterium dafür dienen, wann das zu verdampfende Material verbraucht bzw. der Tiegel nachzufüllen ist.

In einer Reihe von Anwendungen, insbesondere bei kleinen Elektronenstrahl-Verdampferanlagen, ist lediglich die Festhaltung der Auftreffstelle des Elektronenstrahls im Mittenbereich der Targetoberfläche von Interesse. Dies ist vor allem dann der Fall, wenn die Oberfläche des Targets und die Querschnittsfläche des auftreffenden Elektronenstrahls in vergleichbarer Größe liegen. Darüberhinaus ist bei solchen Anlagen oftmals die Überwachung und Regelung der Strahlposition nur entlang einer bestimmten Achsenrichtung notwendig, da aus konstruktiven Gründen maßgebliche Schwankungen der Elektronenstrahlposition aufgrund thermischer oder anderer Effekte nur entlang einer bestimmten Achsenrichtung auftreten.

Wenn, wie im oben zitierten Fall, nur die exakte Erkennung und Regelung einer ausgezeichneten Position - z. B. der Mittenposition - des Auftreffpunkts eines Ladungsträgerstrahls auf einem Target gefordert ist, so genügt es, ein Signal zu erzeugen, das eine stetige, monotone Funktion der Auftreffposition ist und das bei der ausgezeichneten Position einen bestimmten Wert - z. B. Null - annimmt. Ein eindeutiger und linearer Zusammenhang zwischen einem solchen Signal und den Ortskoordinaten jeder möglichen Strahlposition ist in diesem Fall nicht erforderlich. Um den Einfluß einer Niveauänderung des Schmelzgutes auf das Ortssignal eines solchen Detektors - der im folgenden als "Mittenpositionsdetektor" bezeichnet wird - zu eliminieren, kann gemäß der vorliegenden Erfindung ein positionsempfindlicher Detektor, der Positionsempfindlichkeit entlang der zu überwachenden Koordinatenachse aufweist, in der Weise über dem Target angeordnet werden, daß die Projektion der Symmetrieachse des Detektors auf die Targetoberfläche genau durch jenen Punkt auf der Oberfläche verläuft, dessen Position exakt erkannt werden soll.

Der mit dieser Anordnung erzielte Vorteil besteht insbesondere darin, daß stets dann, wenn der Elektronenstrahl seine Mittenposition erreicht, ein vom Schmelzgutniveau unabhängiges Nulldurchgangssignal erzeugt wird. Ein Ausführungsbeispiel für einen erfindungsgemäßen Mittenpositionsdetektor ist im folgenden näher beschrieben.

Die Fig. 4 zeigt in einer Projektion in die xz-Ebene einen erfindungsgemäßen Elektronenstrahl-Mittenpositionsdetektor 50, der an einer Verdampferquelle 51 montiert ist. Der Abbildungsmaßstab beträgt etwa 1 : 1. In der Verdampferquelle 51 befindet sich ein Tiegel 52, der gestrichelt dargestellt ist. Mit 53 ist die vertikale Achse des Tiegels 52 bezeichnet, die zugleich die Richtung eines senkrecht auf die nicht dargestellte Schmelzgutoberfläche auftreffenden Elektronenstrahls anzeigt. Die Symmetrieachse des Positionsdetektors 50 ist mit 54 bezeichnet; sie schneidet im Punkt 55 die vertikale Achse 53.

Mit Hilfe eines Montageprofils 56 und über eine Montageplatte 57 ist der Positionsdetektor 50 mit der Verdampferquelle 51 verbunden. Das Montageprofil 56 ist hierbei mit der Montageplatte 57 hart verlötet. Ein weiteres Montageprofil 58, das mit dem erstgenannten Montageprofil 56 durch zwei Zylinderschrauben 59, 60 verbunden ist, ist mit dem Positionsdetektor 50 hart verlötet.

Der Positionsdetektor 50 arbeitet nach dem Prinzip der "Röntgen-Lochkamera". Dabei wird die von der Auftreffstelle des Elektronenstrahls 4 auf dem Target 2 ausgehende Röntgenstrahlung über eine Lochblende auf einen positionsempfindlichen Fotodetektor abgebildet. Die vom Detektor gelieferten Signale werden elektronisch verstärkt und weiterverarbeitet.

Mit der in der Fig. 4 dargestellten Anordnung soll insbesondere erreicht werden, daß der Elektronenstrahl 53 mit Hilfe einer Regeleinrichtung auf die Mitte des Tiegels 52 eingeregelt werden kann, wobei nur die bezüglich der Drift kritische y'-Ablenkung überwacht wird. Der Positionsgeber 50 liefert also ein Spannungssignal, das proportional zur Abweichung des Elektronenstrahl-Auftreffpunkts von der Tiegelmitte ist, wobei über etwaige rasche Strahlbewegungen bzw. Strahloszillationen gemittelt wird. Die Detektorgeometrie ist so gewählt, daß die Mittenposition des Elektronenstrahls 53 unabhängig vom Füllstand des Schmelztiegels 52 richtig erkannt wird.

Im Betrieb wird das Gehäuse des Positionsgebers 50 gemeinsam mit anderen Bereichen der Anlage evakuiert. Das Vakuum ist jedoch keine Betriebsbedingung für den Positionsdetektor, sondern lediglich für den Elektronenstrahlverdampfer selbst.

Mit der Anordnung gemäß Fig 4 wird die z-Koordinate nicht explizit bestimmt, es wird jedoch deren Einfluß auf die angezeigten x-y-Koordinaten einer ausgezeichneten Position eliminiert. Im Vergleich zu dem aus der EP-0 184 680 Al bekannten Positionsdetektor läßt sich der Mittenpositionsdetektor kostengünstiger aufbauen, weil das Positionssignal nicht über den ganzen möglichen Auftreffbereich des Strahls eine lineare Funktion der Ortskoordinate sein muß. Auch der Umstand, daß die beschriebene Verhältnisbildung und Logarithmierung der Detektorsignale mittels eines einzigen integrierten Bausteins durchgeführt werden kann, reduziert die Kosten der Positionserkennung, zumal die Vermeidung eines Analog-Dividierers oder anderer relativ aufwendiger Bauelemente nicht erforderlich ist. Darüber hinaus ergibt sich durch das Logarithmieren der Vorteil einer sehr hohen Dynamik.

In der Fig. 5 ist der Positionsdetektor 50 in vergrößertem Maßstab und geschnitten dargestellt. Man erkennt hierbei eine Schutzkappe 62 , die in eine Nut 63 auf dem äußeren Umfang eines Gehäuses 64 eingreift, welches innen hohl ist. Mittels einer Blattfeder 65, die an einer Nase 66 der Schutzkappe 62 befestigt ist, wird hierbei eine Blende 67 gegen das Gehäuse 64 gedrückt. Zwischen der Schutzkappe 62 und dem vorderen Bereich des Gehäuses 64 übernimmt die Blende 67 die Funktion einer Röntgenstrahl-Lochblende. Eine Schutzfolie 69 ist zwischen die Blende 67 und die Schutzkappe 62 eingeklemmt. Bei dieser Schutzfolie 69 kann es sich um eine dünne Aluminiumfolie handeln, welche den eigentlichen Detektor vor Bedampfung schützt. Sie kann auf einfache Weise jeweils beim Wechseln der Substrate erneuert werden, um eine zu große Intensitätsabschwächung der zu detektierenden Röntgenstrahlen durch die auf der Folie 69 entstehende zusätzliche Schicht zu vermeiden. Der innere Hohlraum 70 des Gehäuses 64 ist nach vorne, also in Richtung auf die eintretenden Röntgenstrahlen, durch die Schutzfolie 69 und nach hinten durch eine weitere Schutzfolie 71 abgeschlossen, bei der es sich um eine Trennfolie handelt, welche im Falle einer Beschädigung der Folie 69 deren Schutzfunktion übernimmt. Diese letztgenannte Schutzfolie 71 ist zwischen ein Stützblech 72 und eine Halterung 73 eingespannt. Hinter der Halterung 73 befindet sich eine Detektor-Trägerplatte 74 mit einem Detektor 75. An diese Detektor-Trägerplatte 74 schließt ein Gehäusedeckel 76 an, der über Zylinderschrauben 78 mit dem Gehäuse 64 verbindbar ist und zwischen sich und dem Gehäuse 64 die Detektor-Trägerplatte 74 einklemmt. Ein Gummiwulst 79 ist in einer Nut des Gehäusedeckels 76 angeordnet, die sich etwa in der Mitte dieses Deckels 76 befindet. Dieser Gummiwulst berührt die Detektor-Trägerplatte 74. Um den Hohlraum 70 des Gehäuses 64 herum ist ein Kühlwasserkanal 80 gelegt, der über ein Kupferrohr 81 mit Kühlwasser von ca. 10 bis 25 °C gespeist wird.

Der Elektronenstrahl-Positionsgeber 50 kann in Verbindung mit einer entsprechenden Auswerte- und Steuerelektronik manuell oder automatisch betrieben werden.

Im manuellen Betrieb erfolgt lediglich die Überwachung der Strahlposition und gegebenenfalls die Anzeige einer Abweichung aus der Tiegelmitte über eine LED-Reihe, jedoch keine Positionsregelung und keine Abschaltung des Elektronenstrahl-Verdampfers im Fehlerfall.

Im Automatikbetrieb wird das von dem Detektor 75 gelieferte Positionssignal in eine Leistungsstufe für die y-Ablenkung des Elektronenstrahls 53 eingespeist und einem mittels Potentiometer an einer Fernbedienung gewählten Stellwert für den y-Ablenkstrom überlagert.

Wie eine Auswerteschaltung für das Detektorsignal aufgebaut sein kann, zeigt die Fig. 6.

Der positionsempfindliche Detektor 90 wird aus zwei nebeneinanderliegenden, großflächigen (ca. 10 mm x 10 mm) Fotodioden 91, 92 gebildet. Dies stellt eine besonders kostengünstige Lösung bei gleichzeitiger guter Ausnützung der zu detektierenden Röntgenstrahlung dar. Das eigentliche Detektorsignal wird aus dem Verhältnis der Stromsignale der beiden Fotodioden 91, 92 gebildet.

Wie anhand von Versuchen gezeigt werden konnte, ist bei bekannten Silizium-Fotodioden (z. B. Siemens BPY 63 P, Hamamatsu S 2387, Hamamatsu S 1227, Hamamatsu S 1723) im Bereich von Elektronenstrahlprimärspannungen zwischen 6 kV und 12 kV ein Anstieg der Röntgenstrahlempfindlichkeit mit wachsender Primärenergie zu erkennen.

Wegen der stark vom verwendeten Targetmaterial abhängigen Röntgenausbeute - die Intensität der Röntgenbremsstrahlung ist proportional zur Ordnungszahl des Targets; zusätzlich werden charakteristische Röntgenlinien angeregt - und wegen der unterschiedlichen Absorption der Strahlung in der vor dem Detektor befindlichen Aluminium-Schutzfolie ergeben sich für verschiedene Targetmaterialien stark unterschiedliche Detektorsignale. Dennoch sind die Röntgenintensitäten selbst bei niedri gen Beschleunigungsspannungen von 6 kV und Targetmaterialien mit geringer Röntgenausbeute ausreichend, um auch bei

geringsten Emissionsströmen ($\geq$ 10 mA) eine einwandfreie Detektion zu ermöglichen. Dies ist vor allem für die Realisierung eines automatischen Einschaltvorgangs eines Elektronenstrahlverdampfers von Bedeutung.

Hauptaufgabe der in der Fig. 6 dargestellten Auswerteelektronik für die Fotodioden 91, 92 ist die Bildung eines stetigen, monoton vom Ort der auf den Detektor 90 treffenden Strahlung abhängigen, jedoch von der Strahlungsintensität unabhängigen Positionssignals. Diese Aufgabe kann, wie vorangehend beschrieben, durch eine Auswerteschaltung 45, 46 gelöst werden.

Gemäß der vorliegenden Erfindung wird nun anstelle der Differenz zweier Ströme als intensitätsunabhängiges Positionssignal das Stromverhältnis $I_1/I_2$ bzw. dessen Logarithmus herangezogen.

Der Vorteil des Verfahrens liegt u. a. darin, daß die Verknüpfung der Signale mit Hilfe eines einzigen integrierten Bausteins, z. B. LOG 100 von Burr Brown, mit sehr geringem zusätzlichem Schaltungsaufwand realisiert werden kann und daß infolge der Logarithmierung ein extrem hoher Dynamikbereich in der Größenordnung 1 : $10^6$ ohne die Notwendigkeit einer Bereichsumschaltung erzielt wird, was bei kleinen Elektronenstrahl-Verdampferanlagen von großer Bedeutung ist. In der Fig. 6 ist ein solcher integrierter Baustein 93 als logarithmischer Verstärker bezeichnet. Dieser liefert an seinem Ausgang ein Spannungssignal $U_p$, das dem folgenden funktionalen Zusammenhang genügt:

$$U_p = k \log \frac{I_1}{I_2} \qquad\qquad (XIX)$$

Dabei ist k eine durch äußere Beschaltung des Verstärkers 93 einstellbare Konstante, $I_1$ und $I_2$ sind die von den Fotodioden 91 bzw. 92 gelieferten Ströme. Das so erzeugte Signal $U_p$ ist unabhängig von der Gesamtintensität der auf die Fotodioden treffenden Röntgenstrahlung, da bei einer Änderung der Strahlungs-Gesamtintensität sich immer beide Detektorströme $I_1$ und $I_2$ im gleichen Verhältnis ändern. Immer dann, wenn die Position des Auftreffpunkts des Elektronenstrahls in Richtung der Y-Achse in der Targetmitte liegt, sind die Detektorströme $I_1$ und $I_2$ gleich groß und das Signal $U_p$ erreicht nach der Gleichung (XIX) den Wert Null. Aufgrund der gewählten Detektoranordnung ist dies unabhängig von der z-Koordinate des Elektronenstrahls, d. h. unabhängig vom Schmelzgutniveau, der Fall. Verschiebt sich die Elektronenstrahlposition entlang der Y-Achse, so verändert sich das Verhältnis der Detektorströme $I_1$ und $I_2$ und das Signal $U_p$ nimmt - je nach Richtung der Verschiebung - positive oder negative Werte an. Diese Werte des Signals $U_p$ sind nun aus geometrischen Gründen nicht mehr unabhängig vom Schmelzgutniveau, jedoch kann eine Veränderung der z-Koordinate niemals einen Vorzeichenwechsel von $U_p$ bewirken. Auch bei konstanter z-Koordinate ist die Abhängigkeit des Signals $U_p$ von der y-Koordinate nicht linear, doch sind die Abweichungen im interessierenden Bereich gering und insbesondere dann tolerierbar, wenn es - wie hier -nur auf die exakte Bestimmung der Mittenposition ankommt. Das so erzeugte Signal $U_p$ ist somit - entsprechend der oben definierten Anforderung - eine stetige, monotone Funktion der y-Koordinate des Auftreffpunkts des Elektronenstrahls und kann daher als Regelkriterium für die Regelung der y-Koordinate des Elektronenstrahls auf die Targetmitte herangezogen werden. Eine Verschiebung der Elektronenstrahlposition entlang der X-Achse auf dem Target hat lediglich eine Änderung der gesamten, auf beide Detektoren treffenden Röntgenstrahlungsintensität zur Folge und bewirkt daher keine Änderung des Signals $U_p$.

Die Fotodioden 91, 92 werden in der Regel mit negativer Vorspannung betrieben. Mit höherer Sperrspannung sinken die Sperrschichtkapazitäten der Fotodioden 91, 92, wodurch ihre Ansprechgeschwindigkeit steigt. Außerdem ist bei Betrieb mit Vorspannung ein exakt linearer Zusammenhang zwischen Lichtintensität und Fotostrom über einen größeren Bereich gegeben. Deshalb werden die Fotodioden 91, 92 in der Schaltungsanordnung gemäß Fig. 6 mit einer stabilisierten Vorspannung 96 betrieben. Dabei wird der in die Dioden 91, 92 fließende Strom durch eine Gesamtstrommessung 97 gemessen und angezeigt.

Das aus dem logarithmischen Verstärker 93 kommende Positionssignal wird auf einen Integrator 98 gegeben, der über die Strahloszillation mittelt und ein Signal abgibt, das als Positionsanzeige verwendet werden kann.

Neben der eigentlichen Positionserkennung, die durch die Blöcke 90, 93, 96, 97, 98 charakterisiert ist, hat die in der Fig. 6 gezeigte Auswerteelektronik noch einige Zusatzfunktionen, z. B. Automatisierung des Einschaltvorgangs, Notabschaltung im Fehlerfall etc.

Wie aus dem unteren Teil der Prinzipdarstellung der Fig. 6 ersichtlich, erfolgt bei der Stellung "manuell" eines Schalters 99, der eine Fehlererkennungsschaltung 94 beaufschlagt, lediglich die Überwachung der Strahlposition und gegebenenfalls die Anzeige einer Abweichung aus der Tiegelmitte, jedoch keine Positionsregelung und keine Abschaltung im Fehlerfall.

In der Stellung "Automatik" des Schalters 99 wird das vom Detektor 90 gelieferte Positionssignal, das aus dem Integrator 98 kommt, in eine nicht dargestellte Leistungsendstufe für die y-Ablenkung des Elektronenstrahls eingespeist und dem mittels Potentiometer an der Fernbedienung bzw. am Ablenksteuergerät gewählten Stellwert für den y-Ablenkstrom überlagert.

Versagt die Strahlablenkung während des Betriebs, beispielsweise indem der Elektronenstrahl aus dem Sichtfeld des Detektors 90 herausläuft, so wird dies durch die Fehlererkennungsschaltung 94 erkannt, die eine Notabschaltung des Elektronenstrahl-Verdampfers auslöst. Ebenso wird ein Über- bzw. Unterschreiten des zulässigen Eingangsstrompegels für den logarithmischen Verstärker 93 von dieser Fehlererkennungsschaltung 94 erkannt, die dann ebenfalls eine Notabschaltung auslöst.

Weiterhin ist eine Erkennungsschaltung 95 vorgesehen, deren Aufgabe darin besteht, zu unterscheiden, ob es sich beim Einschalten der Hochspannungs versorgung für den Elektronenstrahl-Verdampfer um eine Neueinschaltung, d. h. um eine Aufnahme des Betriebs nach einer Betriebspause, oder um eine Wiedereinschaltung nach einer kurzzeitigen Hochspannungsunterbrechung, z. B. infolge eines Überschlags, handelt. Im erstgenannten Fall wird der Emissionsstrom durch eine Begrenzerschaltung 102 so lange auf ca. 10 bis 20 mA begrenzt, bis der Detektor die richtige Positionierung des Elektronenstrahls meldet. Diese Emissionsstrombegrenzung erfolgt unabhängig von einem am Potentiometer 103 voreingestellten Wert für den Emissionsstrom. Falls innerhalb einer geeignet gewählten Anlaufzeit, die durch ein Zeitglied 104 bestimmt wird, die richtige Strahlpositionierung vom Detektor 90 nicht erkannt wird - beispielsweise weil eine falsch eingestellte oder fehlerhafte Strahlablenkung vorliegt -, erfolgt eine Abschaltung der Hochspannungsversorgung mit entsprechender Fehlermeldung.

Nach einer kurzzeitigen Hochspannungsunterbrechung, z. B. nach einem Überschlag, wird erneut eingeschaltet. Falls nach Ablauf der durch ein Zeitglied 101 gegebenen Einschaltzeit keine Erkennung der richtigen Strahlpositionierung erfolgt, wird ebenfalls eine Hochspannungsabschaltung mit entsprechender Fehlermeldung ausgelöst.

## Ansprüche

1. Einrichtung zum Erkennen der Auftreffstelle eines Ladungsträgerstrahls auf einem Target, wobei die von der Auftreffstelle ausgehenden Röntgenstrahlen durch einen an einer ersten Stelle befindlichen positionsempfindlichen Detektor erkannt werden und ein Abbildungssystem vorgesehen ist, welches alle Positionen, die die Auftreffstelle einnehmen kann, erfaßt und auf der Detektorfläche des positionsempfindlichen Detektors abbildet, wobei die Bildkoordinaten in einem monotonen funktionalen Zusammenhang mit den Koordinaten der Auftreffstelle stehen und der positionsempfindliche Detektor Ausgangssignale abgibt, welche ihrerseits monoton von den Koordinaten eines ersten Bildes der Auftreffstelle abhängen, **dadurch gekennzeichnet,** daß außer dem ersten positionsempfindlichen Detektor (22) für die Ermittlung von Positionen der erwähnten Auftreffstelle wenigstens ein zweiter positionsempfindlicher Detektor (23) vorgesehen ist, der einen vorgegebenen Abstand von dem ersten positionsempfindlichen Detektor (22) hat und Ausgangssignale abgibt, die monoton von den Koordinaten eines zweiten Bildes der Auftreffstelle abhängen, und daß die Ausgangssignale der Detektoren einer Auswerte-Einrichtung zugeführt sind, welche alle drei Raum-Koordinaten der Auftreffstelle des Ladungsträgerstrahls ermittelt.

2. Einrichtung nach Anspruch 1, **dadurch gekennzeichnet,** daß die Flächen-Koordinaten, welche in den Ausgangssignalen der positionsempfindlichen Detektoren (22, 23) enthalten sind, zu den x- und y-Koordinaten der Auftreffstelle des Ladungsträgerstrahls im kartesischen Koordinatensystem (20) korrelieren, welche im wesentlichen parallel zur Oberfläche des Targets (26) verlaufen, und daß in diesen Ausgangssignalen eine dritte Koordinate enthalten ist, welche zu der z-Koordinate der Auftreffstelle im kartesischen Koordinatensystem (20) korreliert, die zur Oberfläche des Targets (26) senkrecht steht.

3. Einrichtung nach Anspruch 2, **dadurch gekennzeichnet,** daß die positionsempfindlichen Detektoren (22, 23) jeweils vier Ströme ($I_1$ bis $I_4$ bzw. $I_5$ bis $I_8$) abgeben, die jeweils als vier Ströme ($I_1$ bis $I_4$ bzw. $I_5$ bis $I_8$) einer Auswerteschaltung (45 bzw. 46) zugeführt sind, von denen jede zwei Ausgangsspannungen ($U_{x1}$, $U_{y1}$ bzw. $U_{x2}$, $U_{y2}$) bereitstellt, welche die Flächen-Koordinaten des ersten bzw. des zweiten Bildes der Auftreffstelle des Ladungsträgerstrahls repräsentieren, wobei die eine Ausgangsspannung ($U_{x1}$) der einen Auswerteschaltung (45) und die eine Ausgangsspannung ($U_{x2}$) der anderen Auswerteschaltung (46) einem ersten Summenbildner (47) sowie einem Differenzbildner (49) zugeführt sind, während die andere Ausgangsspannung ($U_{y1}$) der einen Auswerteschaltung (45) und die andere Ausgangsspannung ($U_{y2}$) der anderen Auswerteschaltung (46) einem zweiten Summenbildner (48) zugeführt sind, und daß das Ausgangssignal ($U_x$) des ersten Summenbildners (47) einer ersten Raumkoordinate (z. B. x) proportional ist, während das Ausgangssignal ($U_y$) des zweiten Summenbildners (48) einer zweiten Raumkoordinate (z. B. y) und das Ausgangssignal ($U_z$) des Differenzbildners (49) einer dritten Raumkoordinate (z. B. z) proportional sind.

4. Einrichtung nach Anspruch 1, **dadurch gekennzeichnet,** daß die beiden positionsempfindlichen Detektoren (22, 23) oberhalb des Targets (26) angeordnet sind, und daß sich zwischen den Detektoren (22, 23) und dem Target (26) zwei Lochblenden (24, 25) befinden, von denen die eine Lochblende (24) den Auftreffpunkt (z. B. 29) auf den einen Detektor (22) und die andere Lochblende (25) den Auftreffpunkt (29) auf den anderen Detektor (23) abbildet.

5. Einrichtung nach Anspruch 4, **dadurch gekennzeichnet,** daß die beiden Blenden (24, 25) jeweils denselben Normalabstand (b) von der Oberfläche (27) des Targets (26) sowie jeweils denselben Normalabstand (a) zu den Sensorflächen der ihnen zugeordneten Detektoren (22 bzw. 23) haben.

6. Einrichtung nach den Anspruch 1, **dadurch gekennzeichnet,** daß von einem Auftreffpunkt (29) eine erste gedachte Gerade durch ein Loch (33) der einen Blende (24) auf den einen Detektor (22) führt, während von diesem Auftreffpunkt (29) eine zweite gedachte Gerade durch ein Loch (34) der anderen Blende (25) auf den anderen Detektor (23) führt, wobei die Projektion (31) der ersten gedachten Gerade in die von den Koordinatenachsen X und Z aufgespannte Ebene einen Winkel ($\epsilon_1$) mit dem Lot (30) der Targetoberfläche (27) einschließt, während die Projektion (32) der zweiten gedachten Gerade in dieselbe Ebene einen Winkel ($\epsilon_2$) mit diesem Lot (30) einschließt.

7. Einrichtung nach Anspruch 6, **dadurch gekennzeichnet,** daß die Projektion der ersten gedachten Gerade in die von den Koordinatenachsen Y und Z aufgespannte Ebene einen Winkel ($\delta_1$) mit dem Lot (30) der Targetoberfläche (27) einschließt, während die Projektion der zweiten gedachten Gerade in dieselbe Ebene einen Winkel ($\delta_2$) mit diesem Lot (30) einschließt.

8. Einrichtung nach den Ansprüchen 6 und 7, **dadurch gekennzeichnet,** daß die Detektoren (22, 23) und die Lochblenden (24, 25) in der Weise oberhalb der Oberfläche (27) des Targets (26) angeordnet sind, daß bei $\epsilon_1 = \epsilon_2$ und $\delta_1 = \delta_2$ der Auftreffpunkt (29) des Ladungsträgerstrahls ein ausgezeichneter Punkt (z. B. der Mittelpunkt) der Oberfläche (27) des Targets (26) ist.

9. Einrichtung nach Anspruch 8, **dadurch gekennzeichnet,** daß eine Regelanordnung vorgesehen ist, welche aufgrund der ermittelten Koordinatenspannungen ($U_x$, $U_y$, $U_z$) den Ladungsträgerstrahl derart ablenkt, daß die Bedingungen $\epsilon_1 = \epsilon_2$ und $\delta_1 = \delta_2$ gelten und somit der Ladungsträgerstrahl an dem ausgezeichneten Punkt auf der Oberfläche (27) des Targets (26) gehalten wird.

10. Einrichtung nach Anspruch 1, **dadurch gekennzeichnet,** daß die positionsempfindlichen Detektoren jeweils durch Aneinanderreihung zweier oder mehrerer Fotosensoren gebildet werden, die für sich genommen keine Positionsempfindlichkeit aufweisen.

11. Einrichtung nach Anspruch 1, **dadurch gekennzeichnet,** daß die strahlungsempfindlichen Oberflächen der beiden Detektoren (22, 23) in ein und derselben Ebene liegen, welche zu der von den Koordinatenachsen X und Y aufgespannten Ebene parallel ist, wobei diese Detektoren (22, 23) Positionsempfindlichkeiten entlang der X-Achse aufweisen und Signale ($U_{x1}$ bzw. $U_{x2}$) liefern, und daß das ausschließlich von der Z-Koordinate des Auftreffpunkts (29) des Ladungsträgerstrahls auf dem Target (26) abhängige Signal ($U_z$) proportional ist zum Verhältnis zweier Terme, wobei der erste Term aus der Differenz der Signale ($U_{x1}$ und $U_{x2}$) und der zweite Term aus einer ersten Konstanten abzüglich der Differenz der Signale ($U_{x1}$ und $U_{x2}$) gebildet sind.

12. Einrichtung nach Anspruch 1, **dadurch gekennzeichnet,** daß die strahlungsempfindlichen Oberflächen der beiden Detektoren (22, 23) in ein und derselben Ebene liegen, welche zu der von den Koordinatenachsen X und Y aufgespannten Ebene parallel ist, wobei diese Detektoren (22, 23) Positionsempfindlichkeiten entlang der Y-Achse aufweisen und Signale ($U_{y1}$ bzw. $U_{y2}$) liefern, und daß das ausschließlich von der Z-Koordinate des Auftreffpunkts (29) des Ladungsträgerstrahls auf dem Target (26) abhängige Signal ($U_z$) proportional ist zum Verhältnis zweier Terme, wobei der erste Term aus der Differenz der Signale ($U_{y1}$ und $U_{y2}$) und der zweite Term aus einer zweiten Konstanten abzüglich der Differenz der Signale ($U_{y1}$ und $U_{y2}$) gebildet sind.

13. Einrichtung nach den Ansprüchen 11 oder 12, **dadurch gekennzeichnet,** daß das ausschließlich von der X-Koordinate des Auftreffpunkts (29) des Ladungsträgerstrahls auf dem Target abhängige Signal ($U_x$) proportional ist zur Summe aus zwei Termen, wobei der erste Term aus dem Produkt einer dritten Konstanten mit der Summe der Signale ($U_{x1}$ und $U_{x2}$) und der zweite Term aus dem Produkt des Signals ($U_z$) mit der Summe der Signale ($U_{x1}$ und $U_{x2}$) gebildet sind.

14. Einrichtung nach Anspruch 1 1 oder 12, **dadurch gekennzeichnet,** daß das ausschließlich von der Y-Koordinate des Auftreffpunkts (29) des Ladungsträgerstrahls auf dem Target (26) abhängige Signal ($U_y$) proportional ist zur Summe aus zwei Termen, wobei der erste Term aus dem Produkt einer vierten Konstanten mit der Summe der Signale ($U_{y1}$ und $U_{y2}$ und der zweite Term aus dem Produkt des Signals ($U_z$) mit der Summe der Signale ($U_{y1}$ und $U_{y2}$ gebildet sind.

15. Einrichtung nach Anspruch 11, **dadurch gekennzeichnet,** daß das ausschließlich von der Z-Koordinate des Auftreffpunkts (29) des Ladungsträgerstrahls auf dem Target (26) abhängige Signal ($U_z$)

proportional ist zur Differenz der Signale ($U_{x1}$ und $U_{x2}$).

16. Einrichtung nach Anspruch 12, **dadurch gekennzeichnet,** daß das ausschließlich von der Z-Koordinate des Auftreffpunkts (29) des Ladungsträgerstrahls auf dem Target (26) abhängige Signal ($U_z$) proportional ist zur Differenz der Signale ($U_{y1}$ und $U_{y2}$).

17. Einrichtung nach Anspruch 11, **dadurch gekennzeichnet,** daß das ausschließlich von der X-Koordinate des Auftreffpunkts (29) des Ladungsträgerstrahls auf dem Target (26) abhängige Signal ($U_x$) proportional ist zur Summe der Signale ($U_{x1}$ und $U_{x2}$).

18. Einrichtung nach Anspruch 12, **dadurch gekennzeichnet,** daß das ausschließlich von der Y-Koordinate des Auftreffpunkts (29) des Ladungsträgerstrahls auf dem Target (26) abhängige Signal ($U_y$) proportional ist zur Summe der Signale ($U_{y1}$ und $U_{y2}$).

19. Einrichtung nach Anspruch 1, **dadurch gekennzeichnet,** daß zwei Detektoren vorgesehen sind, wobei der erste Detektor Positionsempfindlichkeit entlang der X-Achse aufweist und ein von der Röntgenstrahlungsintensität unabhängiges Signal $U_{x1}$ liefert und der zweite Detektor Positionsempfindlichkeit entlang der Y-Achse aufweist und ein von der Röntgenstrahlungsintensität unabhängiges Signal $U_{y1}$ liefert und daß die Detektorsignale $U_{x1}$ und $U_{y1}$ jeweils ausschließlich von den Koordinaten x bzw. y des Auftreffpunkts des Ladungsträgerstrahls auf dem Target abhängen und insbesondere von der Koordinate z unabhängig sind, wenn der Auftreffpunkt mit dem Schnittpunkt zwischen der zur X-Achse senkrecht stehenden Symmetrieebene der strahlungsempfindlichen Oberfläche des ersten Detektors und der zur Y-Achse senkrecht stehenden Symmetrieebene der strahlungsempfindlichen Oberfläche des zweiten Detektors und der Targetoberfläche zusammenfällt.

20. Einrichtung nach Anspruch 19, **dadurch gekennzeichnet,** daß die von der Röntgenstrahlungsintensität unabhängigen Signale $U_{x1}$ und $U_{y1}$ aus dem Verhältnis der Ausgangsströme der jeweiligen Photosensoren oder aus dessen Logarithmus gewonnen werden.

21. Einrichtung nach Anspruch 1, **dadurch gekennzeichnet,** daß ein Verdampfergehäuse (51) vorgesehen ist, an dem über Haltevorrichtungen (56, 57, 58) Detektoren (50) vorgesehen sind.

22. Einrichtung nach Anspruch 21, **dadurch gekennzeichnet,** daß der Detektor (50) eine Positionsempfindlichkeit entlang einer ausgezeichneten Richtung aufweist, in der die Auftreffposition (55) des Ladungsträgerstrahls (53) auf dem Target Schwankungen aufgrund thermischer und anderer Effekte unterworfen ist.

23. Einrichtung nach Anspruch 1, **dadurch gekennzeichnet,** daß die Detektoren (50) in einem Gehäuse (64) vorgesehen sind, das an seiner Vorderseite eine Blende (67) aufweist, die mittels einer Schutzkappe (62) mit dem Gehäuse (64) in Verbindung steht, und das an seiner Rückseite eine Sensorträgerplatte (74) aufweist, die mittels eines Gehäusedeckels (76) gegen das Gehäuse (64) gedrückt ist.

24. Einrichtung nach Anspruch 23, **dadurch gekennzeichnet,** daß zwischen der Blende (67) und der Schutzkappe (62) eine Schutzfolie (69) vorgesehen ist.

25. Einrichtung nach Anspruch 23, **dadurch gekennzeichnet,** daß das Gehäuse (64) auf seinem Umfang einen Kühlkanal (80) aufweist, durch den ein Kühlmittel strömt.

26. Einrichtung nach Anspruch 23, **dadurch gekennzeichnet,** daß die Sensorträgerplatte (74) zwischen dem Gehäusedeckel (76) und einer Halterung (73) angeordnet ist, wobei zwischen dieser Halterung (73) und einem Stützblech (72) eine Schutzfolie (71) vorgesehen ist.

EP 0 379 739 A2

FIG.1a

FIG.1b

FIG. 2

FIG.3

EP 0 379 739 A2

FIG.5

FIG.4

FIG. 6

Photodiode 91

Photodiode 92

90

$I_1$

$I_2$

93

Log. Verstärker

$U_P$

Mittelung über Strahloszillation

Integrator

98

Positionsanzeige

97

Gesamtstrom-Messung

96

Stabilisierte Vorspannung

Intensitätsanzeige

95

Erkennung:

Neu-Einschaltung / Einschaltung nach HV-Überschlag

HV ein

HV 8.2

nach HV-Überschlag

101

Zeitglied 2

104

Zeitglied 1

neu

102

Emissionsstrom-Begrenzung

103

Freigabe der Not-Abschaltung

Freigabe Emissionsstrom

94

Fehler-Erkennung

Regelsignal für LES 05

Fehlermeldungen Not-Abschaltung

99

Manuell    Automatik

EP 0 379 739 A2